# EUROPÄISCHE PATENTSCHRIFT

(11) **EP 0 488 015 B1**
(45) Veröffentlichungstag und Bekanntmachung des Hinweises auf die Patenterteilung: **30.10.1996**
(21) Anmeldenummer: 91119667.3
(22) Anmeldetag: 18.11.1991
(51) Int. Cl.: G01R 33/38

(54) **Homogenfeldmagnet mit mindestens einer mechanisch auszurichtenden Polplatte**
Magnet system for a homogeneous field with at least one mechanically adustable polar piece
Aimant pour champ homogène avec au moins une pièce polaire ajustable mécaniquement

(30) Priorität: 30.11.1990 DE 4038265
(43) Veröffentlichungstag der Anmeldung: 03.06.1992
(73) Patentinhaber: SIEMENS AKTIENGESELLSCHAFT, 80333 München (DE)
(72) Erfinder: Siebold, Horst, Dr., W-8520 Erlangen (DE); Ries, Günter, Dr., W-8520 Erlangen (DE); Röckelein, Rudolf, W-8520 Erlangen (DE)

(56) Entgegenhaltungen:
- EP-A- 0 161 782
- EP-A- 0 170 318
- WO-A-85/05448
- DE-A- 3 737 133
- US-A- 4 707 663
- PATENT ABSTRACTS OF JAPAN Band 10, Nr. 240 (E- 429)(2296), 19 August 1986;& JP - A - 6171606 (FUJI ELEC.) 12.04.1986

## Beschreibung

Die Erfindung bezieht sich auf einen Homogenfeldmagneten mit einem den magnetischen Fluß führenden Joch und zwei gegenüberliegenden Polschuhen, zwischen denen ein Nutzvolumen mit einem Magnetfeld hoher Homogenität ausgebildet ist und die jeweils auf ihrer dem Nutzvolumen zugewandten Seite profiliert sind, wobei mindestens einer der Polschuhe mit einer Polplatte versehen ist, die gegenüber einem dem Joch zugewandten Basisteils des Polschuhes über einen schmalen Korrekturluftspalt beabstandet ist und zur Korrektur des Magnetfeldes mittels mechanischer Stellvorrichtungen zu kippen und/oder zu biegen ist. Ein entsprechender Homogenfeldmagnet ist z.B. aus der DE-OS 3737133 bekannt.

Homogenfeldmagnete sind insbesondere zur Erzeugung magnetischer Grund felder in Anlagen zur Kernspintomographie (Nuclear-Magnetic-Resonance-Tomography, -Imaging oder -Spectroscopy) erforderlich. Das Magnetfeld derartiger Grundfeldmagnete muß dabei in einem Abbildungs- bzw. Untersuchungsbereich (Nutzvolumen) hinreichend homogen sein und dort eine vorbestimmte magnetische Induktion B_{O} erzeugen. Dabei werden für magnetische Induktionen B_{O} > 0,5 T im allgemeinen supraleitende Spulensysteme vorgesehen. Demgegenüber sind geringere magnetische Induktionen (B_{O} < 0,5 T) auch mit normalleitenden Spulen oder Permanentmagneten zu erzeugen. Letztere Magnete sind vielfach als Polschuhmagnete mit einem Eisenjoch in Form eines "C" ausgebildet. Zwischen den Polflächen ihrer gegenüberliegenden Polschuhe liegt dann das Nutzvolumen mit der geforderten Feldhomogenität. Insbesondere für die Anforderungen der Kernspintomographie ist wegen der unvermeidlichen Herstellungstoleranzen die anfänglich erreichbare Feldhomogenität im Nutzvolumen nicht ausreichend. Es muß vielmehr am fertigen Magneten eine Korrekturmöglichkeit bestehen, um so durch eine abwechselnde Folge von Feldmessungen und Feldkorrekturen den Feldfehler sukzessive verringern zu können (Shimmung).

Aus der EP-A-0161782 geht ein permanenterregter Polschuhmagnet hervor, welcher eine Reihe mechanischer Feldkorrekturmöglichkeiten aufweist. Seine Polschuhe sind im Bereich der Polflächen als justierbare Polplatten gestaltet, die an ihren dem Nutzvolumen zugewandten Oberflächen so profiliert sind, daß insbesondere Randeffekte, welche die Homogenität beeinflussen, kompensiert werden. Sie sind deshalb in ihren Randbereichen mit den gegenseitigen Abstand zwischen den Polschuhen verringernden Randstücken in Form von wulstartigen Erhebungen versehen. Die beiden Polplatten liegen dabei jeweils unmittelbar an dem ihnen zugeordneten Permanentmagneten bzw. an flußführenden Teilen eines Eisenjoches an.

Um derartige profilierte Polplatten gegenseitig hinreichend exakt ausrichten und Feldfehler korrigieren zu können, ist bei dem aus der eingangs genannten DE-0S 37 37 133 zu entnehmenden Homogenfeldmagneten mindestens eine der Polplatten nicht unmittelbar an dem einen magnetischen Fluß führenden Eisenjoch befestigt. Vielmehr ist die profilierte Polplatte gegenüber einem dem Joch zugewandten Basisteil des Polschuhes über einen schmalen Korrekturluftspalt beabstandet, wobei sie mittels besonderer Stellvorrichtungen kipp- und/oder biegbar ausgebildet ist. Der Luftspalt wirkt dabei als magnetischer Serienwiderstand feldhomogenisierend, indem er Flußdichteinhomogenitäten in flußführenden Teilen des Polschuhs beim Flußübertritt in die jeweilige Polplatte ausgleicht.

Aufgabe der vorliegenden Erfindung ist es, die mechanischen Feldkorrekturmöglichkeiten des Homogenfeldmagneten mit den eingangs genannten Merkmalen weiter zu verbessern und zu vereinfachen. Dabei soll nur eine verhältnismäßig geringe magnetische Flußdichtekomponente in der Ebene der Polplatte vorhanden sein, um so ein gutes Eindiffundieren von zusätzlichen magnetischen Flüssen zu ermöglichen, die insbesondere von gepulsten Gradientenfeldern zur Kernspintomographie herrühren. Nichtlinearitäten dieser Gradientenfelder sollen dabei weitgehend vermieden werden.

Diese Aufgabe wird erfindungsgemäß durch den in Anspruch 1 definierten Magneten gelöst.

Die mit dieser Ausgestaltung des Homogenfeldmagneten verbundenen Vorteile sind insbesondere darin zu sehen, daß seine mindestens eine Polplatte einfachst herzustellen ist. Sie weist eine große mechanische Biegbarkeit auf, die einen verhältnismäßig geringen Kraftaufwand für mechanische Stellvorrichtungen zur Homogenisierung des magnetischen Grundfeldes erfordert. Dadurch ist eine sehr feine Einstellgenauigkeit zu gewährleisten. Da die Polplatte magnetisch von dem Polschuh und von dessen Randstück abgekoppelt ist, wird eine deutliche Verringerung der radialen Flußdichtekomponente in der Polplatte und insbesondere in deren Randzone erreicht. Der Polschuh und dessen Randstück tragen nun im wesentlichen den radialen Magnetfluß. Es läßt sich so ein weitgehend verzögerungsfreies Einschalten von Gradientenfeldern erreichen.

Vorteilhafte Ausgestaltungen des erfindungsgemäßen Homogenfeldmagneten gehen aus den Unteransprüchen hervor.

Zur weiteren Erläuterung der Erfindung wird nachfolgend auf die schematische Zeichnung Bezug genommen, in deren Figur 1 eine Ausführungsform eines erfindungsgemäßen Homogenfeldmagneten angedeutet ist. Figur 2 gibt einen vergrößerten Ausschnitt aus einem Polschuh dieses Magneten wieder. Figur 3 zeigt als Diagramm den zeitlichen Verlauf von Gradientenfeldstärken an Polplatten entsprechender Homogenfeldmagnete. Aus dem Diagramm der Figur 4 sind radiale Flußdichtekomponenten in Polplatten zu entnehmen. In den Figuren sind übereinstimmende Teile mit denselben Bezugszeichen versehen.

Bei einem erfindungsgemäßen Homogenfeldmagneten wird von bekannten Ausführungsformen ausgegangen, wie sie sich insbesondere für die Kernspintomographie vorsehen lassen. Nicht näher erläuterte Teile des Magneten entsprechen deshalb denen dieser bekannten Ausführungsformen. Der Magnet ist als Polschuhmagnet ausgebildet, wobei er die folgenden allgemeinen Gestaltungsmerkmale aufweist:
- Die einander zugewandten Polflächen der Polschuhe mit runder, quadratischer oder rechteckiger Polfläche sind gemäß den Homogenitätsfelderfordernissen profiliert bzw. strukturiert.
- Mindestens einer seiner beiden Polschuhe umfaßt in einem mittleren, zentralen Bereich eine besondere Polplatte, die durch einen Korrekturluftspalt beabstandet ist.
- Als magnetfelderzeugende Einrichtungen sind entweder Erregerspulen oder Permanentmagnete vorgesehen, wobei diese Einrichtungen im allgemeinen nahe an den Polschuhen angeordnet sind.
- Die Polschuhe sind über ein den magnetischen Fluß führendes Joch aus einem entsprechenden magnetischen Material verbunden, wobei dieses Joch ein- oder mehrschenklig ausgebildet sein kann.
- Es sind die erfindungsgemäßen Maßnahmen zu einer mechanischen Shimmung vorgesehen.

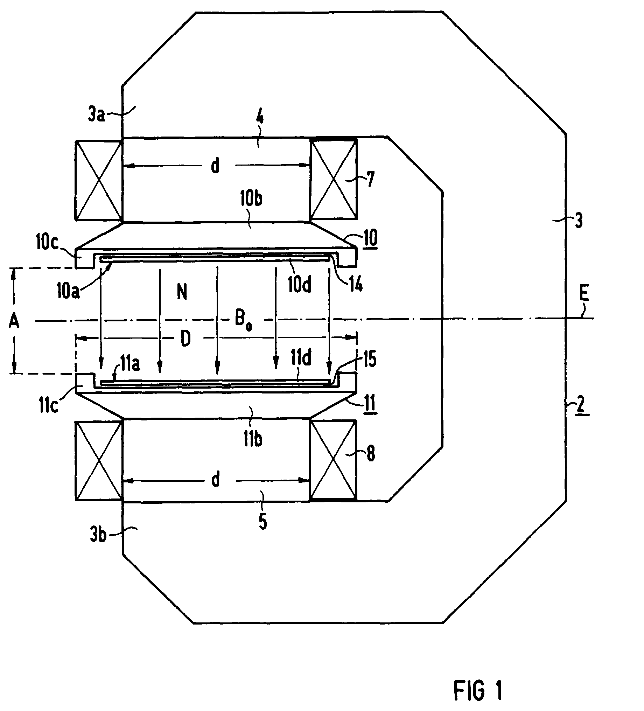

Ein entsprechendes Magnetkonzept liegt auch dem Homogenfeldmagneten zugrunde, der aus dem schematischen Längsschnitt der Figur 1 hervorgeht. Dieser allgemein mit 2 bezeichnete Magnet weist ein einschenkliges magnetisches Joch 3 z.B. aus Eisen auf. Er wird vielfach auch wegen der Gestaltungsform seines Joches 3 als C-Magnet bezeichnet. Die beiden gegenüberliegenden, freien Schenkelenden 3a bzw. 3b des Joches 3 münden jeweils in einen wenigestens annähernd zylinderförmigen Kern 4 bzw. 5 aus ferromagnetischem Material. Diese aufeinander zuführenden Kerne mit Durchmesser d sind dabei jeweils von einer eigenen Erregerspule 7 bzw. 8 umschlossen. An den den Schenkelende 3a bzw. 3b abgewandten Seiten gehen die beiden Kerne 4 und 5 jeweils in einen Polschuh 10 bzw. 11 mit größerem Polschuhdurchmesser D über. Es ergibt sich so ein zu einer Symmetrieebene E zumindest weitgehend symmetrischer Aufbau des gesamten Magneten 2.

Zwischen den mit vorbestimmtem Abstand A in zumindest weitgehend parallel der Symmetrieebene E liegenden Polflächen 10a bzw. 11a der beiden Polschuhe 10 bzw. 11 ist ein Zwischenraum oder Nutzvolumen N ausgebildet. In diesem Nutzvolumen soll ein zur Kernspintomographie hinreichend homogenes Magnetfeld herrschen, das von beiden Erregerspulen 7 und 8 hervorgerufen wird. Mit normalleitenden Spulen sind dabei in dem Nutzvolumen durch gepfeilte Linien angedeutete magnetische Induktionen Bₒ zu erreichen, die durch die Sättigungsmagnetisierung des Jochmaterials begrenzt sind und so z.B. unter 0,5 T liegen.

Jeder der Polschuhe 10 und 11 enthält einen magnetfeldführenden Basisteil 10b bzw. 11b, der über den jeweiligen Kern 4 oder 5 mit dem Joch 3 verbunden ist. Jeder Basisteil 10b bzw. 11b hat bis auf einen Randbereich eine ebene freie Fläche und weist in diesem Randbereich ein den gegenseitigen Abstand A verringerndes wulstartiges Randstück 10c bzw. 11c auf. Diese ringförmigen Randstücke dienen zur Feldkorrektur am Außenrand der Polschuhe und werden deshalb auch als "Feldkorrekturringe" bezeichnet. In jedem von diesen Randstücken umgrenzten inneren (zentralen) Bereich der Polschuhe ist bei mindestens einem dieser Polschuhe, vorzugsweise aber bei beiden Polschuhen, jeweils eine besondere Polplatte 10d bzw. 11d angeordnet. Jede Polplatte soll dabei von ihrem zugeordneten Basisteil durch einen schmalen Korrekturluftspalt beabstandet sein. In der Figur ist der zwischen dem Basisteil 10b und der Polplatte 10d liegende Korrekturspalt mit 14 bezeichnet. Der Korrekturspalt 15 liegt entsprechend zwischen dem Basisteil 11b und der Polplatte 11d. Im allgemeinen befinden sich in unmittelbarer Nähe der dem Nutzvolumen N zugewandten Oberflächen 10a und 11a der Polplatten 10d und 11d in der Figur nicht dargestellte Gradientenspulen zur Erzeugung von zur Kernspintomographie erforderlichen gepulsten Gradientenfeldern.

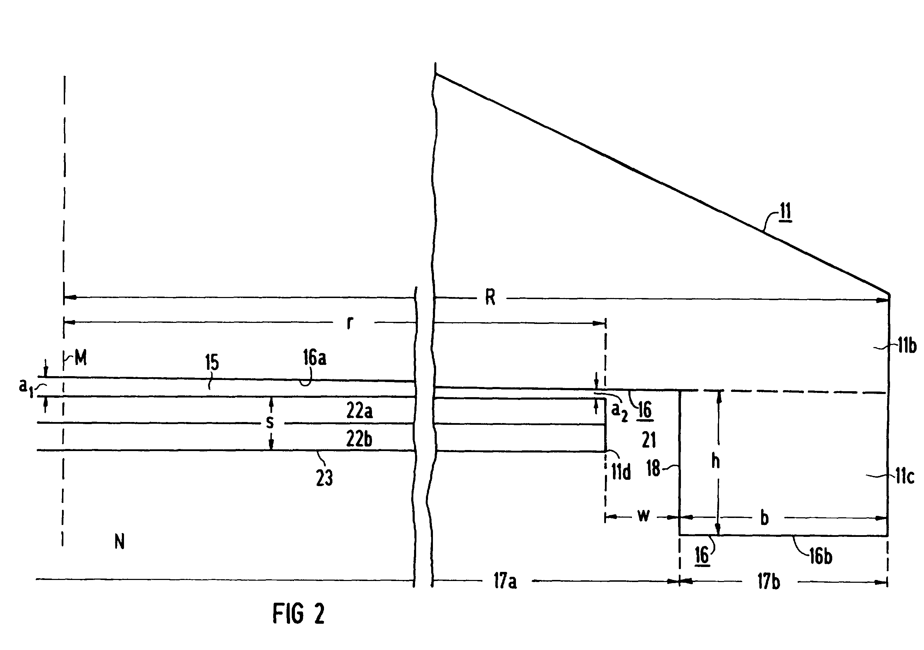

Weitere Gestaltungsmerkmale der profilierten Basisteile sowie der Polplatten gehen aus dem in Figur 2 gezeigten Längsschnitt hervor. In dieser Figur ist ein vergrößerter Ausschnitt aus dem Polschuh 11 des Magneten 2 nach Figur 1 dargestellt. Entsprechende Gestaltungsmerkmale können auch für den Polschuh 10 vorgesehen werden. Es ist jedoch auch möglich, daß bei diesem Polschuh der Basisteil 10b und die Polplatte 10d als ein einziges profiliertes Bauteil mit entsprechend strukturierter Oberfläche 10a ausgeführt sind.

Aus dem in Figur 2 gezeigten Schnitt durch einen Teil des Polschuhes 11 ist der eine weitgehend trapezförmige Schnittfläche aufweisende Basisteil 11b mit einer gestuften Oberfläche 16 ersichtlich. Dieser Teil 11b stellt die Verlängerung eines in der Figur nicht dargestellten, beispielsweise zylinderförmigen ferromagnetischen Kernes (5) dar, der von einer normalleitenden Erregerspule (8) umschlossen ist. Gegebenenfalls können dieser Kern und der Basisteil 11b ein gemeinsames Bauteil bilden. Die Oberfläche 16 des Basisteils 11b ist in einen mittleren Oberflächenteil 16a eines mittleren, zentralen Polbereichs 17a und in einen äußeren Oberflächenteil 16b eines Randbereichs 17b unterteilt. Zwischen diesen beiden Bereichen ist eine Stufe 18 ausgebildet, so daß sich ein Randstück 11c des Basisteils mit beispielsweise rechteckiger Querschnittsfläche ergibt. Die Höhe h des Randstücks 11c bzw. der Abstand zwischen den Ebenen des mittleren Oberflächenteils 16 a und des äußeren Oberflächenteils 16b an der Stufe 18 kann zwischen 20 und 50 mm, beispielsweise etwa 40 mm betragen. Die radiale Breite b des Randstücks 11c bzw. des äußeren Oberflächenteils 16b liegt dabei im allgemeinen zwischen 40 und 80 mm, beispielsweise bei etwa 60 mm. Das Randstück 11c, dessen Schnittfläche auch eine andere Gestalt haben kann, beispielsweise trapezförmig ist, kann z.B. als eigenes Bauteil an den Basisteil 11b angefügt sein. In diesem Fall besteht die Möglichkeit, das Randstück aus einem Material zu erstellen, dessen magnetische Eigenschaften gegenüber denen des übrigen Basisteils verschieden sind. Gemäß dem dargestellten Ausführungsbeispiel ist jedoch angenommen, daß das Randstück 11c zusammen mit dem Basisteil 11b ein gemeinsames Formstück bildet.

In dem mittleren, zentralen Polbereich 17a ist von dem Oberflächenteil 16a durch einen schmalen Korrekturluftspalt 15 getrennt die Polplatte 11d angeordnet. Dabei soll zwischen dem Außenrand der Platte und dem Randstück 11c ein radialer Spalt 21 der Weite w verbleiben. Die Spaltweite w liegt im allgemeinen zwischen etwa 2 und 20 mm. Allgemein sollte gelten, daß die Polplatte 11d weniger als 85 % der Gesamtfläche 16 des Polschuhs 11 einnimmt. Für eine bezüglich einer Linie (Achse) M durch seine Mitte rotationssymmetrischen Basisteil 11b kann dann insbesondere für den Radius r der Polplatte 11d gelten: r < 0,9·R, wobei R der maximale Außenradius des Basisteils 11b bzw. seines Randstücks 11c ist. Stellvorrichtungen zum Fixieren sowie zum Kippen und/oder Biegen der Polplatte 11d sind hinlänglich bekannt (vgl. die genannte DE-OS 37 37 133). Auf die Darstellung dieser Vorrichtungen wurde deshalb in Figur 2 verzichtet. Die Polplatte 11d weist vorteilhaft eine rechteckige Querschnittsfläche auf, wobei sie verhältnismäßig dünn ausgebildet ist. So liegt ihre konstante Dicke oder Stärke s zwischen 0,3 cm und 3 cm, vorzugsweise zwischen 5 mm und 15 mm. Für die Platte 11d wird vorteilhaft zumindest zu einem Teil ein magnetisches Material mit hoher relativer Permeabilität µᵣ und hoher Flußtragfähigkeit Bₘₐₓ gewählt. So kann z.B. eine massive, magnetisch isotrope Platte aus einer Si-Fe-Legierung mit einem µᵣ ≈ 4000 und einem Bₘₐₓ ≈ 1,6 T verwendet werden. Dieses Material hat eine elektrische Leitfähigkeit von etwa 2,5 . 10⁶ S/m. Entsprechende Polplatten sind besonders einfach herzustellen.

Um gegenüber einer Polplatte aus massivem Material eine erhöhte mechanische Flexibilität zu gewährleisten, läßt sich vorteilhaft die Polplatte 11d auch durch einen Stapel aus mehreren Blechen, z.B. gebräuchlichen Elektroblechen aus einer Si-Fe-Legierung, mit jeweils einer Dicke zwischen etwa 1 mm und 5 mm erstellen.

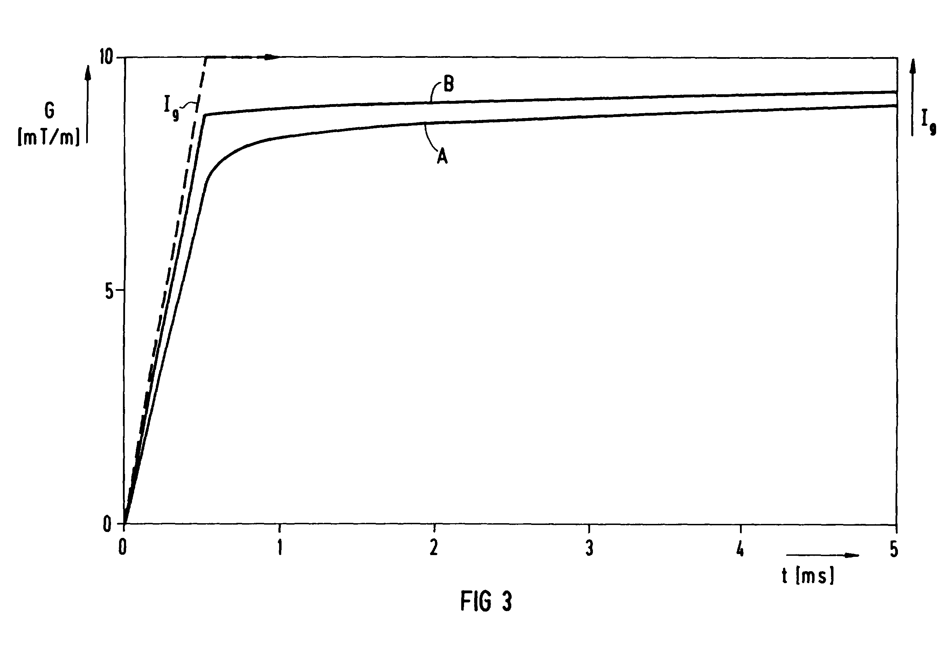

Ferner kann, wie für das Ausführungsbeispiel nach Figur 2 angenommen, die Polplatte 11d einen geschichteten Aufbau aus zwei etwa gleich dicken Schichten 22a und 22b haben, wobei für diese Schichten unterschiedliche Materialien gewählt sind. Die erste, dem Korrekturluftspalt 15 zugewandte Schicht 22a läßt sich z.B. aus einem oder mehreren, jeweils 1 bis 5 mm dicken Elektroblechen aus einer Si-Fe-Legierung erstellen, so daß eine hinreichende Flexilität des gesamten Aufbaus gewährleistet ist. Demgegenüber kann die zweite, dem Nutzvolumen N zugewandte Schicht 22b beispielsweise aus weichmagnetischem Ferrit oder aus einem kunststoffgebundenen Eisenpulver bestehen. Bei einer relativen Permeabilität µᵣ von etwa 1000 und einer Flußtragfähigkeit Bₘₐₓ von etwa 0,4 T bis 0,5 T läßt sich vorteilhaft eine nur geringe elektrische Leitfähigkeit dieser Schicht gewährleisten. Die erste, hochpermeable Schicht 22a sorgt für eine gute Grundfeldhomogenität. Die zweite Schicht 22b trägt kurzzeitig den zusätzlichen magnetischen Fluß, der von zur Kernspintomographie erforderlichen Gradientenspulen während der Pulsanstiegszeit des Gradientenstromes hervorgerufen wird. Diese in der Figur 2 nicht dargestellten Gradientenspulen befinden sich in bekannter Weise in unmittelbarer Nähe der dem Nutzvolumen N zugewandten Oberfläche 23 der Schicht 22b. Mit dem gezeigten Schichtaufbau wird vorteilhaft eine nahezu verzögerungsfreies Einschalten des Gradientenfeldes erreicht. Es werden nämlich die Pulsform verschleifende magnetische Diffusionsvorgänge, wie sie bei einer Polplatte aus rein ferromagnetischem und elektrisch leitfähigem Material auftreten, im wesentlichen unterdrückt. Dieser Sachverhalt ist aus dem Diagramm der Figur 3 abzulesen. In diesem Diagramm sind in Richtung der Abszisse die Zeit t (in ms) und in Richtung der Ordinate die im Nutzvolumen N zu messende Gradientenfeldstärke G (in mT/m) für ein konkretes Ausführungsbeispiel aufgetragen. Die mit A bezeichnete Kurve ist dabei einer Polplatte aus massivem Elektroblech zugeordnet, während sich die Kurve B für eine Polplatte 11d mit dem in Figur 2 gezeigten und vorstehend erläuterten Aufbau aus den Schichten 22a und 22b mit unterschiedlichem magnetischen Verhalten und unterschiedlicher elektrischer Leitfähigkeit ergibt. Außerdem ist durch eine gestrichelte Linie der zeitliche Verlauf eines Pulses des Gradientenstromes I_{g} angedeutet, der in etwa 0,5 ms auf seinen Maximalwert angestiegen ist. Dabei ist die Größe dieses Stromes in Ordinatenrichtung in willkürlichen Einheiten angegeben. Wie aus einem Vergleich der Kurven A und B hervorgeht, wird mit dem Schichtaufbau der Polplatte 11d wesentlich schneller der stationäre Wert der Gradientenfeldstärke erreicht (Kurve B) als mit einer Polplatte aus einheitlichem magnetischen Material, das elektrisch leitfähig ist (Kurve A). Bei letzterer Polplatte muß ein wesentlich längeres Einschwingen des Pulses abgewartet werden, bevor dessen Gradientenfeld nutzbar ist.

Wie ferner aus Figur 2 hervorgeht, ist vorteilhaft in dem Korrekturluftspalt 15 der Abstand (bzw. die Weite) zwischen dem mittleren Oberflächenteil 16a des Basisteils 11b und der Polplatte 11d nicht über die gesamte radiale Ausdehnung gesehen konstant. Vielmehr ist im Bereich der zentrale Achse M der Abstand a₁ größer als der Abstand a₂ im Bereich des Außenrandes der Platte. Während a₁ im allgemeinen zwischen 3 und 5 mm liegt, ist a₂ mindestens um 20 %, vorzugsweise mindestens um 30 %, und höchstens um 60 % kleiner als a₁. Die Differenz a₁ - a₂ kann z.B. zwischen 1 und 2 mm liegen. Die Abstandsabnahme von a₁ auf a₂ läßt sich insbesondere durch eine entsprechende konische Eindrehung (Ausfräsung) des Basisteils 11b erreichen. Sie braucht nicht kontinuierlich zu verlaufen, sondern es kann auch eine stufenweise Abnahme vorgesehen werden.

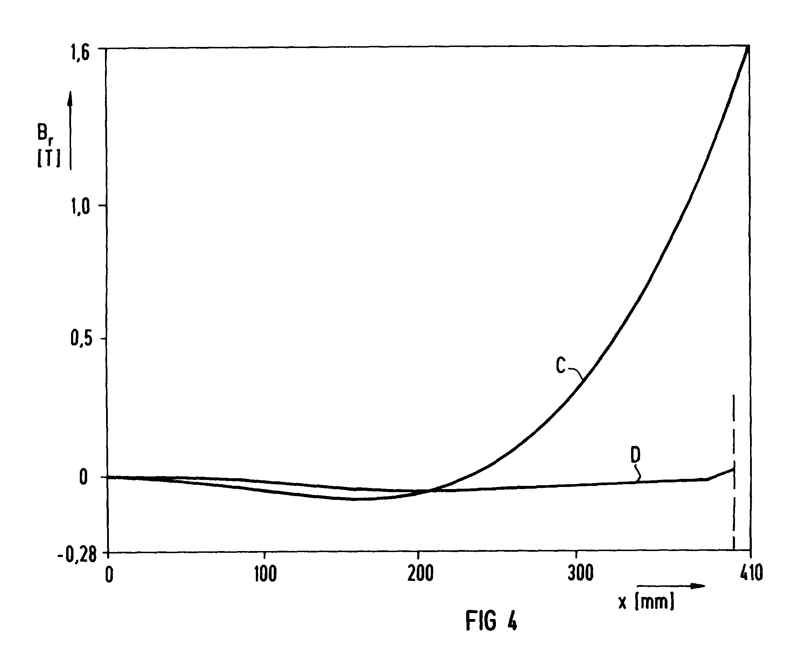

Mit der erfindungsgemäßen Ausgestaltung einer Polplatte 11d nur im mittleren Bereich 17a unter Ausbildung eines seitlichen Spaltes 21 gegenüber einem ringförmigen, wulstartigen Randstück 11c des Basisteils und der konischen Ausbildung des Korrekturluftspaltes 15 wird eine deutliche Verringerung einer unerwünschten radialen Flußdichtekomponente in der Polplatte 11d erreicht. Das Diagramm der Figur 4 belegt diesen Sachverhalt. In diesem Diagramm sind in Richtung der Abszisse die radiale Ausdehnung x von zwei Polplatten, gemessen in mm von der zentralen Achse M aus, und in Richtung der Ordinate die an der Unterseite der jeweiligen Polplatte auftretende radiale Flußdichtekomponente Bᵣ (in T) aufgetragen. Der mit C bezeichnete Kurvenverlauf ergibt sich für eine konkrete Polplatte, die gemäß der genannten DE-OS 37 37 133 Figur 2, ausgebildet ist. Diese Polplatte mit einer radialen Ausdehnung x von 500 mm besteht im wesentlichen aus 15 mm starkem Elektroblech und enthält selbst in ihrem äußeren Randbereich ein ringförmiges, wulstartiges Randstück, das etwa 60 mm breit (in radialer Richtung) ist. Die Platte ist im Bereich dieses Randstückes etwa 40 mm dick. Kurve D wird für eine erfindungsgemäß ausgebildete Polplatte 11d gemäß Figur 2 aus dem gleichen Material und mit derselben, konstanten Stärke s, jedoch ohne Randstück 11c erhalten. Die radiale Ausdehnung x beträgt 400 mm. Wie aus einem Verleich beider Kurven deutlich hervorgeht, wird mit den erfindungsgemäßen Maßnahmen insbesondere im Randbereich der Polplatte 11d ein unerwünschter Anstieg der radialen Flußdichtekomponente Bᵣ weitgehend unterdrückt. Dies ist darauf zurückzuführen, daß die Polplatte 11d sowohl von dem Basisteil 11b des Polschuhs sowie von dem ringartigen Randstück 11c magnetisch abgekoppelt ist; das heißt, die Teile 11b und 11c tragen nun im wesentlichen den radialen Magnetfluß. Den konkreten Verlauf der radialen Flußdichtekomponente Bᵣ legen dabei auch die konische Erweiterung des Korrekturluftspaltes 15 und/oder die Materialauswahl für die Platte 11d fest.

## Patentansprüche

1. Homogenfeldmagnet (2) mit einem den magnetischen Fluß führenden Joch (3) und zwei gegenüberliegenden Polschuhen (10, 11), zwischen denen ein Nutzvolumen (N) mit einem Magnetfeld (B_{O}) hoher Homogenität ausgebildet ist und die jeweils auf ihrer dem Nutzvolumen (N) zugewandten Seite profiliert sind,
wobei
1) mindestens einer der Polschuhe (10, 11) mit einer Polplatte (10d, 11d) versehen ist, die gegenüber einem dem Joch (3) zugewandten Basisteil (10b, 11b) des Polschuhs (10, 11) über einen schmalen Korrekturluftspalt (14, 15) beabstandet ist und zur Korrektur des Magnetfeldes (B_{O}) mittels mechanischer Stellvorrichtungen zu kippen und/oder zu biegen ist,
2) jeder Polschuh (10, 11) an seinem Randbereich (17b) als Teil seines magnetischen Polschuhkörpers ein den gegenseitigen Abstand (A) zwischen den Polschuhen (10, 11) verringerndes Randstück (10c, 11c) aufweist
und
3) die kipp- und/oder biegbare Polplatte (10d, lld) des mindestens einen Polschuhs (10,11) in dem von dem Randstück (10c, 11c) umgrenzten inneren Bereich (17a) um einen seitlichen Spalt (21) mit einer Weite (w) zwischen 2 und 20 mm gegenüber dem Randstück (10c, 11c) beabstandet angeordnet ist.

2. Magnet nach Anspruch 1, **dadurch gekennzeichnet**, daß die Polplatte (10d, 11d) aus mehreren Schichten (22a, 22b) zusammengesetzt ist.

3. Magnet nach Anspruch 2, **dadurch gekennzeichnet**, daß die dem Nutzvolumen (N) zugewandte Schicht (22b) der Polplatte (11d) eine verhältnismäßig geringe elektrische Leitfähigkeit hat.

4. Magnet nach einem der Ansprüche 1 bis 3, **dadurch gekennzeichnet**, daß die Polplatte (10d, 11d) eine konstante Stärke (s) zwischen 3 und 30 mm, vorzugsweise zwischen 5 und 15 mm aufweist.

5. Magnet nach einem der Ansprüche 1 bis 4, **dadurch gekennzeichnet**, daß der Korrekturluftspalt (14, 15) am Außenrand der Polplatte (10d, 11d) eine geringere Weite (a₂) hat als in der Mitte (M) der Platte.

6. Magnet nach Anspruch 5, **dadurch gekennzeichnet**, daß die Weite (a₂) des Korrekturluftspaltes (14, 15) am Außenrand der Polplatte (10d, 11d) um mindestens 20 %, vorzugsweise um mindestens 30 %, und um höchstens 60 % geringer ist als die Weite (a₁) in der Mitte (M) der Platte.

7. Magnet nach Anspruch 5 oder 6, **dadurch gekennzeichnet**, daß zu einer Vergrößerung des Korrekturluftspaltes (14, 15) der Basisteil (10b, 11b) des Polschuhs (10, 11) eine entsprechende konische Eindrehung aufweist.

8. Magnet nach einem der Ansprüche 1 bis 7, d**a-durch gekennzeichnet**, daß die Fläche (23) der Polplatte (10d, 11d) weniger als 85 % der Gesamtfläche (16) des Polschuhs (10, 11) einnimmt.

## Claims

1. Homogenous field magnet (2) having a yoke (3), which carries the magnetic flux, and two opposing pole shoes (10, 11), between which is formed a useful volume (N) having a magnetic field (B_{O}) of great homogeneity, and which are each profiled on the side which faces the useful volume (N), with
1) at least one of the pole shoes (10, 11) being provided with a pole plate (10d, 11d), which is distanced with respect to a base portion (10b, 11b) of the pole shoe (10, 11), which base portion faces the yoke (3), by way of a narrow correction air gap (14, 15) and is to be tilted and/or bent by means of mechanical positioning devices in order to correct the magnetic field (B_{O}),
2) each pole shoe (10, 11) having at its edge region (17b), as part of its magnetic pole shoe body, an edge piece (10c, 11c) which reduces the mutual distance (A) between the pole shoes (10, 11), and
3) the pole plate (10d, 11d) of the at least one pole shoe (10, 11), which pole plate can be tilted and/or bent, being arranged in the inner region (17a), which is delimited by the edge piece (10c, 11c), in a manner such that it is distanced with respect to the edge piece (10c, 11c) by a lateral gap (21) having a width (w) of between 2 and 20 mm.

2. Magnet according to claim 1, characterised in that the pole plate (10d, 11d) is made up of a plurality of layers (22a, 22b).

3. Magnet according to claim 2, characterised in that the layer (22b) of the pole plate (11d) that faces the useful volume (N) has a relatively low electrical conductivity.

4. Magnet according to one of the claims 1 to 3, characterised in that the pole plate (10d, 11d) has a constant thickness (s) of between 3 and 30 mm, preferably between 5 and 15 mm.

5. Magnet according to one of the claims 1 to 4, characterised in that the correction air gap (14, 15) has a smaller width (a₂) at the outside edge of the pole plate (10d, 11d) than in the centre (M) of the plate.

6. Magnet according to claim 5, characterised in that the width (a₂) of the correction air gap (14, 15) at the outside edge of the pole plate (10d, 11d) is at least 20%, preferably at least 30%, and at most 60% smaller than the width (a₁) in the centre (M) of the plate.

7. Magnet according to claim 5 or 6, characterised in that in order to enlarge the correction air gap (14, 15), the base portion (10b, llb) of the pole shoe (10, 11) has a corresponding conical recess.

8. Magnet according to one of the claims 1 to 7, characterised in that the surface (23) of the pole plate (10d, 11d) takes up less than 85% of the total surface (16) of the pole shoe (10, 11).

## Revendications

1. Aimant (2) pour champ homogène, comprenant une culasse (3) conduisant le flux magnétique et deux pièces polaires (10, 11) situées l'une en face de l'autre, entre lesquelles est formé un volume utile (N) avec un champ magnétique (B_{O}) de grande homogénéité, et qui sont chacune profilées sur leur face située du côté du volume utile (N),
1) au moins une des pièces polaires (10, 11) étant pourvue d'une plaque polaire (10d, 11d) qui est située à une distance par rapport à une partie de base (10b, 11b) de la pièce polaire (10, 11) située du côté de la culasse (3) et séparée de cette partie de base par un entrefer de correction (14, 15) étroit, et qui peut être basculée et/ou pliée au moyen de dispositifs de réglage mécaniques en vue de la correction du champ magnétique (B_{O}),
2) chaque pièce polaire (10, 11) étant pourvue, dans la région de son bord (17b), d'une pièce de bordure (10c, 11c) réduisant la distance (A) réciproque entre les pièces polaires (10, 11) et faisant partie de son corps de pièce polaire magnétique,
et
3) la plaque polaire (10d, 11d) de la - au moins une - pièce polaire (10, 11), qui peut être basculée et/ou pliée, étant située à distance dans la zone intérieure (17a) délimitée par la pièce de bordure (10c, 11c) de la pièce de bordure (10c, 11c) par une fente latérale (21) ayant une largeur (w) comprise entre 2 et 20 mm.

2. Aimant selon la revendication 1, caractérisé en ce que la plaque polaire (10d, 11d) est composée de plusieurs couches (22a, 22b).

3. Aimant selon la revendication 2, caractérisé en ce que la couche (22b) de la plaque polaire (11d) située du côté du volume utile (N) a une conductibilité électrique relativement faible.

4. Aimant selon l'une des revendications 1 à 3, caractérisé en ce que la plaque polaire (10d, 11d) a une épaisseur (s) constante comprise entre 3 et 30 mm, de préférence entre 5 et 15 mm.

5. Aimant selon l'une des revendications 1 à 4, caractérisé en ce que l'entrefer de correction (14, 15) a une largeur (a₂) plus petite au niveau du bord externe de la plaque polaire (10d, 11d) qu'au milieu (M) de la plaque.

6. Aimant selon la revendication 5, caractérisé en ce que la largeur (a₂) de l'entrefer de correction (14, 15) au niveau du bord externe de la plaque polaire (10d, 11d) est inférieure d'au moins 20%, de préférence d'au moins 30%, et d'au plus 60%, à la largeur (a₁) au milieu (M) de la plaque.

7. Aimant selon la revendication 5 ou 6, caractérisé en ce que la partie de base (10b, 11b) de la pièce polaire (10, 11) est pourvue d'une incision conique correspondante en vue d'une augmentation de l'entrefer de correction (14, 15).

8. Aimant selon l'une des revendications 1 à 7, caractérisé en ce que la surface (23) de la plaque polaire (10d, 11d) occupe moins de 85% de la surface totale (16) de la pièce polaire (10, 11).
